(19)

Europäisches Patentamt

European Patent Office

Office européen des brevets

(11) **EP 4 641 721 A1**

(12) **EUROPÄISCHE PATENTANMELDUNG**

(43) Veröffentlichungstag:
**29.10.2025 Patentblatt 2025/44**

(21) Anmeldenummer: **24172769.2**

(22) Anmeldetag: **26.04.2024**

(51) Internationale Patentklassifikation (IPC):
$H01M\ 10/04^{(2006.01)}$  $H01M\ 10/42^{(2006.01)}$
$H01M\ 10/44^{(2006.01)}$  $H01M\ 10/48^{(2006.01)}$
$G01R\ 31/378^{(2019.01)}$  $G01R\ 31/385^{(2019.01)}$
$H01M\ 10/0525^{(2010.01)}$

(52) Gemeinsame Patentklassifikation (CPC):
**H01M 10/42; G01R 31/378; G01R 31/385;
H01M 10/049; H01M 10/446; H01M 10/48;
H01M 10/0525**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft
80333 München (DE)**

(72) Erfinder:
• **Fischer, Michael
  91320 Ebermannstadt (DE)**
• **Katzer, Felix
  90763 Fürth (DE)**
• **Radinger, Hannes
  90459 Nürnberg (DE)**

(74) Vertreter: **Siemens Patent Attorneys
Postfach 22 16 34
80506 München (DE)**

(54) **ERMITTLUNG EINER LADUNGSMENGE EINER FESTSTOFF-ELEKTROLYT-GRENZPHASE EINER BATTERIEZELLE**

(57)    Es wird ein Verfahren zur Ermittlung einer Ladungsmenge $Q_{SEI}(t)$ einer Feststoff-Elektrolyt-Grenzphase (SEI) einer Batteriezelle (1) vorgeschlagen, wobei die Batteriezelle (1) eine positive und negative Elektrode (11, 12) aufweist, und an die Batteriezelle (1) eine zeitabhängige Spannung V(t) angelegt wird. Das Verfahren ist wenigstens durch folgende Schritte gekennzeichnet:
- Ermitteln einer Ruhespannung $V_0(t)$ der Batteriezelle (1);
- Ermitteln einer Ladungsmenge $Q_+(t)$ der positiven Elektrode (11);
- Ermitteln einer Ladungsmenge $Q_-(t)$ der negativen Elektrode (12) mittels der ermittelten Ladungsmenge der positiven Elektrode $Q_+(t)$ (11) und der ermittelten Ruhespannung $V_0(t)$; und
- Ermitteln der Ladungsmenge $Q_{SEI}(t)$ der Feststoff-Elektrolyt-Grenzphase (SEI) mittels den ermittelten Ladungsmengen $Q_+(t)$, $Q_-(t)$ der Elektroden (11, 12).

Weiterhin betrifft die Erfindung ein Verfahren zur Regelung eines Formierungsprozesses einer Batteriezelle (1), ein Herstellungsverfahren einer Batteriezelle (1) sowie eine Vorrichtung zur Regelung eines Formierungsprozesses einer Batteriezelle (1).

FIG 5

EP 4 641 721 A1

**Beschreibung**

Die Erfindung betrifft ein Verfahren gemäß dem Oberbegriff des Patentanspruches 1, ein Regelungsverfahren gemäß dem Oberbegriff des Patentanspruches 9, ein Herstellungsverfahren gemäß dem Oberbegriff des Patentanspruches 13 sowie eine Vorrichtung gemäß dem Oberbegriff des Patentanspruches 15.

Eine Formierung einer Batteriezelle ist einer der letzten Produktionsschritte in der Zellproduktion. Typischerweise erfolgt dieser Formierungsprozess nachdem die Zelle mit dem Elektrolyten befüllt und verschlossen wurde und bevor die Batteriezelle eingelagert und eine End-of-Line Qualitätskontrolle durchgeführt wird.

Der Formierungsprozess umfasst die ersten Lade- beziehungsweise Entladevorgänge der fertigen Batteriezelle und soll einen definierten und für die spätere Verwendung möglichst optimalen Ausgangszustand sicherstellen. Bei Lithium-Ionen-Zellen und verwandten Technologien wird durch die Formierung die Bildung einer wohldefinierten Feststoff-Elektrolyt-Grenzphase oder Festelektrolyt-Interphase (englisch: Solid Electrolyte Interphase; abgekürzt SEI) an der Oberfläche der Anode angestrebt. Diese bildet sich durch Reaktionen des Elektrolyten mit Elektrolyt-Additiven in bestimmten Spannungs- und gegebenenfalls Temperaturbereichen, die während der Entlade- beziehungsweise Ladevorgänge während des Formierungsprozesses durchlaufen werden.

Innerhalb einer Batteriezelle treten mehrere komplexe Reaktionen simultan auf, die sich in ihrer Reaktionskinetik voneinander unterschieden. Hierbei ist jede elektrochemische Reaktion, insbesondere die Reaktionen, die zur SEI Formierung beitragen, abhängig vom Potential am Ort der Reaktion.

Somit kann es bei falsch eingestelltem zeitlichen Verlauf der vorgegebenen Stromstärke oder der angelegten Spannung dazu kommen, dass sich Potentiale an den Grenzflächen einstellen, die nicht für die Bildung der möglichst optimalen SEI geeignet sind, oder dass bereits weitere Reaktionen, beispielsweise ein Aufladen der Elektrodenmaterialien, beschleunigt stattfinden, die ihrerseits die SEI Formierung negativ beeinflussen. Es ist somit erforderlich, dass der Formierungsprozess geeignete Strom-, Spannungs- und/oder Temperaturverläufe zur Bildung der gewünschten SEI verwendet.

Weiterhin ist die Formierung einer der Zeit- und Energie-intensivsten Prozesse in der Zellproduktion, sodass dieser möglichst effizient sein müssen.

Die genannten technischen Anforderungen sowie die komplexen zugrundeliegenden chemischen Reaktionen stellen hohe technische Ansprüche an die Definition und Kontrolle der Prozessparameter während des Formierungsprozesses.

Bekannte Formierungsprozesse verwenden Stromstärken und gegebenenfalls Spannungs- und Temperaturverläufe basierend auf empirischen Tests an den produzierten Zellen beziehungsweise Batteriezellen. Dabei werden die Prozessparameter derart eingestellt, dass sie einen möglichst guten Kompromiss aus Performance und Prozesskosten darstellen. Falls Messungen zur Kontrolle des Formierungsprozesses verwendet werden, beschränken sich diese auf Strom- und Spannungsmessungen. Beispielsweise wird so lange zyklisiert, bis die gemessene differentielle Kapazität unter einen bestimmten Schwellenwert fällt. Dieses Verfahren erfordert eine möglichst genaue Kenntnis der verfügbaren Prozessfenster und kann dennoch die Streuungen in der Qualität der produzierten Zellen nicht vollständig reduzieren.

Neuere Verfahren zielen darauf ab, die Überspannung während der Formierung zu messen. Dies kann durch die Verwendung von Strompulsen oder Impedanzmessungen erfolgen. Durch eine komplexe Auswertungen der gemessenen Überspannung lässt sich der Formierungsprozess beschleunigen oder verlangsamen, um eine zuverlässigere SEI-Bildung sicherzustellen.

Der vorliegenden Erfindung liegt die Aufgabe zugrunde, ein verbessertes Verfahren zur Ermittlung der Ladungsmenge der Feststoff-Elektrolyt-Grenzphase bereitzustellen und somit einen Formierungsprozess einer Batteriezelle zu verbessern.

Die Aufgabe wird durch ein Verfahren mit den Merkmalen des unabhängigen Patentanspruches 1, durch ein Regelungsverfahren mit den Merkmalen des unabhängigen Patentanspruches 9, durch ein Herstellungsverfahren mit den Merkmalen des unabhängigen Patentanspruches 13 sowie durch eine Vorrichtung mit den Merkmalen des unabhängigen Patentanspruches 15 gelöst. In den abhängigen Patentansprüchen sind vorteilhafte Ausgestaltungen und Weiterbildungen der Erfindung angegeben.

Das erfindungsgemäße Verfahren zur Ermittlung einer Ladungsmenge $Q_{SEI}(t)$ einer Feststoff-Elektrolyt-Grenzphase einer Batteriezelle, wobei die Batteriezelle eine positive und negative Elektrode aufweist, und an die Batteriezelle eine zeitabhängige Spannung $V(t)$ angelegt wird, ist wenigstens gekennzeichnet durch folgende Schritte:

- Ermitteln einer Ruhespannung $V_0(t)$ der Batteriezelle;
- Ermitteln einer Ladungsmenge $Q_+(t)$ der positiven Elektrode;
- Ermitteln einer Ladungsmenge $Q_-(t)$ der negativen Elektrode mittels der ermittelten Ladungsmenge der positiven Elektrode $Q_+(t)$ und der ermittelten Ruhespannung $V_0(t)$; und
- Ermitteln der Ladungsmenge $Q_{SEI}(t)$ der Feststoff-Elektrolyt-Grenzphase mittels den ermittelten Ladungsmengen $Q_+(t)$, $Q_-(t)$ der Elektroden.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt sein.

Gemäß der Erfindung wird die Ladungsmenge ermittelt oder bestimmt, die insbesondere während eines Formierungsprozesses der Batteriezelle zur wenigstens teilweisen Bildung der Feststoff-Elektrolyt-Grenzphase (SEI) aufgewendet wird. Basierend hierauf kann der Formierungsprozess effizienter durchgeführt werden und eine verbesserte Formierung/Ausbildung der SEI sichergestellt werden.

Typischerweise wird während der Formierung beziehungsweise während des Formierungsprozesses eine zeitabhängige Spannung an die Batteriezelle zwischen den Elektroden angelegt. Alternativ oder ergänzend kann eine zeitabhängige Stromstärke vorgesehen beziehungsweise äquivalent zur zeitabhängigen Spannung verwendet werden.

Das erfindungsgemäße Verfahren sieht in einem ersten Schritt vor, die Ruhespannung der Batteriezelle zu einem aktuellen Zeitpunkt zu ermitteln. Das kann mittels bekannter Methoden erfolgen. Besonders bevorzugt wir hierzu die Batteriezelle in einem festgelegten Zeitbereich stromlos geschaltet, wodurch die Spannung auf die Ruhespannung abklingt. Durch das Abklingverhalten kann dann die Ruhespannung ermittelt werden. Ein Abwarten bis die tatsächliche Ruhespannung erreicht ist, ist hierzu nicht erforderlich, kann jedoch vorgesehen sein.

In einem zweiten Schritt des Verfahrens wird die Ladungsmenge der positiven Elektrode ermittelt.

Insbesondere erfolgt dies mittels des Stromflusses $I(t)$ gemäß $Q_+(t) = Q_0 - \int_0^t I(t')\mathrm{d}t'$, wenn die Formierung zum Zeitpunkt $t = 0$ beginnt und zum Beginn der Formierung die gesamte Ladung mittels der positiven Elektrode gespeichert ist, das heißt, dass die negative Elektrode keine Ladung aufweist und sich noch keine SEI an dieser gebildet hat. Mit anderen Worten ist die Batteriezelle zum Beginn vollständig entladen. Somit ist zu Beginn der Formierung $Q_+(t = 0) = Q_0$, $Q_-(t = 0) = 0$ sowie $Q_{SEI}(t = 0) = 0$, wobei $Q_0$ während des Formierungsprozesses zeitunabhängig, das heißt zeitlich konstant ist. Da die Zellchemie und Masse an Elektrodenmaterial als bekannt vorausgesetzt werden kann, ist ebenfalls die maximal zur Verfügung stehende Ladung $Q_0$ bekannt.

Näherungsweise gilt der Zusammenhang $Q_0 = Q_+(t) + Q_-(t) + Q_{SEI}(t)$, sodass sich die mittels der Batteriezelle insgesamt enthaltene Ladungsmenge $Q_0$ durch die mittels der positiven und negativen Elektrode gespeicherten sowie mittels der SEI gebundenen Ladungsmenge zusammensetzt. Hierbei sind Ladungsmengen innerhalb des Elektrolyten nicht aufgeführt, da sie bei der SEI Formierung normalerweise keine elektrisch messbaren Änderungen durchlaufen. Somit werden während der SEI Formierung die Ladungen von der positiven Elektrode entnommen und entweder der negativen Elektrode zugeführt oder zur SEI Formierung verwendet.

Gemäß einem dritten Schritt des Verfahrens wird eine Ladungsmenge $Q_-(t)$ der negativen Elektrode mittels der ermittelten Ladungsmenge der positiven Elektrode $Q_+(t)$ und der ermittelten Ruhespannung $V_0$ $(t)$ ermittelt.

Die Ruhespannung der Batteriezelle hängt über die jeweiligen Ruhepotentiale der Elektroden mit den jeweiligen Ladungsmengen der Elektroden zusammen. Das ist deshalb der Fall, da das jeweilige Ruhepotential lediglich von der Ladungsmenge der jeweiligen Elektrode abhängig ist. Mit anderen Worten gilt für die jeweiligen Ruhepotentiale $\varphi_\pm = \varphi_\pm(Q_\pm)$. Somit kann über die Ruhespannung, die den Potentialunterschied der Ruhepotentiale quantifiziert, und der Ladungsmenge der positiven Elektrode die Ladungsmenge der negativen Elektrode ermittelt beziehungsweise bestimmt werden.

Gemäß dem Verfahren werden somit ebenfalls die Ladungsmenge der positiven und negativen Elektrode ermittelt. Mit anderen Worten sind nach dem dritten Schritt des Verfahrens die jeweiligen Ladungsmengen der Elektroden bekannt.

In einem vierten Schritt des Verfahrens wird die Ladungsmenge $Q_{SEI}(t)$ der Feststoff-Elektrolyt-Grenzphase mittels den ermittelten Ladungsmengen $Q_+(t)$, $Q_-(t)$ der Elektroden ermittelt.

Das ist möglich, da die Ladungsmengen über $Q_0 = Q_+(t) + Q_-(t) + Q_{SEI}(t)$ in Zusammenhang stehen und die Gesamtladungsmenge $Q_0$ vorab bekannt ist.

Das erfindungsgemäße Verfahren ermöglicht die für die tatsächlich gebildete SEI verwendeten Ladungsmenge zu jedem Zeitpunkt, insbesondere während des gesamten Formierungsprozesses, zu ermitteln. Das ist insbesondere deshalb von Vorteil, da die gebildete SEI ein zentrales Qualitätskriterium des Formierungsprozesses darstellt. Dies unterscheidet die Erfindung von bekannten Verfahren, bei denen komplexe Algorithmen und KI-Modelle angewandt werden, um aus einer Vielzahl von elektrischen Messwerten abstrakte Aussagen über den Prozess und dessen Regelung zu treffen.

Das erfindungsgemäße Verfahren zur Regelung (Regelungsverfahren) eines Formierungsprozesses (Formierung) einer Batteriezelle mit einer positiven und negativen Elektrode, wobei zur wenigstens teilweisen Ausbildung einer Feststoff-Elektrolyt-Grenzphase an die Batteriezelle eine zeitabhängige Spannung $V(t)$ angelegt wird, ist gekennzeichnet durch folgende Schritte:

- Bereitstellen einer Sollwertkurve $Q_{SEI}(Q_-)$, wobei $Q_{SEI}$ eine Ladungsmenge der Feststoff-Elektrolyt-Grenzphase und $Q_-$ eine Ladungsmenge der negativen Elektrode bezeichnet; und
- Regeln des Formierungsprozesses gemäß der Sollwertkurve $Q_{SEI}(Q_-)$ durch ein Ermitteln von aktuellen Ladungsmengen $Q_{SEI}(t)$ der Feststoff-Elektrolyt-Grenzphase und von zugehörigen aktuellen Ladungsmengen $Q_-(t)$ der negativen Elektrode gemäß dem erfindungsgemäßen Verfahren zur Ermittlung der Ladungsmenge $Q_{SEI}(t)$ einer Feststoff-Elektrolyt-Grenzphase der Batteriezelle und/oder einer seiner Ausgestaltungen.

Gemäß dem erfindungsgemäßen Regelungsverfahren wird somit eine Sollwertkurve $Q_{SEI}(Q_-)$ für die Ladungsmenge der SEI in Abhängigkeit der Ladungsmenge der negativen Elektrode bereitgestellt. Die Sollwertkurve quantifiziert somit, welche SEI Ladungsmenge bei welcher Ladungsmenge der negativen Elektrode vorliegen soll. Die Sollwertkurve kann als Referenzkurve angesehen werden, wobei diese beispielsweise mittels einer Referenzbatteriezelle (englisch: Golden Sample) gemäß einem Referenzformierungsprozess ermittelt und bereitgestellt werden kann.

Während der Formierung der Batteriezelle beziehungsweise während des Formierungsprozesses werden aktuelle Werte für die SEI Ladungsmenge und für die Ladungsmenge der negativen Elektrode ermittelt oder erfasst. Dies erfolgt wenigstens gemäß dem erfindungsgemäßen Verfahren zur Ermittlung einer Ladungsmenge $Q_{SEI}(t)$, wobei hierbei im dritten Schritt des genannten Verfahrens ebenfalls die Ladungsmenge der negativen Elektrode ermittelt wird.

Das Ermitteln von $Q_{SEI}(t)$ und $Q_-(t)$ erfolgt während des Formierungsprozesses wenigstens zu einem aktuellen Zeitpunkt $t$. Insbesondere werden $Q_{SEI}(t)$ und $Q_-(t)$ während des Formierungsprozesses und im Rahmen der Regelung regelmäßig, beispielsweise zeitlich kontinuierlich, quasi-kontinuierlich und/oder in festgelegten Zeitschritten ermittelt oder erfasst.

Somit werden im Rahmen des erfindungsgemäßen Regelungsverfahren die aktuell ermittelten $Q_{SEI}(t)$ und $Q_-(t)$ in ausreichender Übereinstimmung mit der Sollwertkurve $Q_{SEI}(Q_-)$ gebracht.

Die erfindungsgemäße Verwendung von $Q_{SEI}(Q_-)$ als Regelkurve ist insbesondere deshalb von Vorteil, da diese quantifiziert, wie viel der Gesamtladungsmenge zum jeweiligen Zeitpunkt während des Formierungsprozesses entweder zur Aufladung der negativen Elektrode oder zur Formierung der SEI verwendet wurde. Dadurch wird für eine oder mehrere individuelle Batteriezellen eine möglichst gleiche SEI Formierung zum Golden Sample sichergestellt.

Im Vergleich zu einem Formierungsprozess ohne Regelung ermöglicht die Erfindung einen für jede individuelle Batteriezelle optimierten Prozess. Dabei wird der Prozess durch die erfindungsgemäße Regelung beispielsweise beschleunigt, wenn die ermittelten Ladungsmengen eine schnelle Bildung der SEI andeuten, und verlangsamt, wenn der Prozess die Bildung der gewünschten SEI gefährden würde.

Es ergeben sich zum erfindungsgemäßen Verfahren zur SEI Ladungsbestimmung gleichartige, gleichwertige und gleichwirkende Vorteile und/oder Ausgestaltungen des erfindungsgemäßen Regelungsverfahren.

Das erfindungsgemäße Herstellungsverfahren einer Batteriezelle, bei dem ein Formierungsprozess der Batteriezelle erfolgt, ist gekennzeichnet dadurch, dass der Formierungsprozess mittels eines Verfahrens gemäß einem erfindungsgemäßen Regelungsverfahren und/oder einer seiner Ausgestaltungen geregelt wird.

Es ergeben sich zum erfindungsgemäßen Verfahren zur SEI Ladungsbestimmung und/oder zum erfindungsgemäßen Regelungsverfahren gleichartige, gleichwertige und gleichwirkende Vorteile und/oder Ausgestaltungen des erfindungsgemäßen Herstellungsverfahrens.

Die erfindungsgemäße Vorrichtung zur Regelung eines Formierungsprozesses einer Batteriezelle, ist dadurch gekennzeichnet, dass die Vorrichtung wenigstens eine Regeleinheit umfasst, wobei die Regeleinheit dazu ausgebildet ist, ein Regelungsverfahren gemäß der Erfindung und/oder einer ihrer Ausgestaltungen durchzuführen.

Es ergeben sich zum erfindungsgemäßen Regelungsverfahren gleichartige, gleichwertige und gleichwirkende Vorteile und/oder Ausgestaltungen der erfindungsgemäßen Vorrichtung.

Gemäß einer vorteilhaften Ausgestaltung der Erfindung wird die Ladungsmenge $Q_{SEI}(t)$ über $Q_{SEI}(t) = Q_0 - Q_+(t) - Q_-(t)$ ermittelt, wobei $Q_0$ eine Gesamtladungsmenge der Batteriezelle bezeichnet.

Mit anderen Worten werden Ladungsmengen des Elektrolyten nicht berücksichtigt. Vorteilhafterweise ist diese Näherung ausreichend, da die Ladungsmengen des Elektrolyten bei der SEI Formierung typischerweise keine elektrisch messbaren Änderungen durchlaufen. Somit kann durch die Näherung $Q_{SEI}(t) = Q_0 - Q_+(t) - Q_-(t)$ eine verbesserte und effizientere Ermittlung der SEI Ladungsmenge erfolgen.

In einer vorteilhaften Weiterbildung der Erfindung wird die Ladungsmenge $Q_+(t)$ der positiven Elektrode mittels des mit der angelegten Spannung $V(t)$ assoziierten Stromflusses $I(t)$ ermittelt.

Hierbei kann vereinfachend angenommen, dass zu Beginn der Formierung ($t = 0$) keine Ladung in der negativen Elektrode gespeichert ist und auch noch keine Ladung für die SEI verwendet wurde. Damit ist die Ladung $Q_0$ vollständig in der positiven Elektrode gespeichert, was dem vollständig entladenen Zustand der Batteriezelle entspricht. Da die Zellchemie und Masse an Elektrodenmaterial als bekannt vorausgesetzt werden kann, ist ebenfalls die Ladung $Q_0$ bekannt. Während der Formierung wird der Strom $I(t)$ zwischen den beiden Elektroden gemessen. Da dieser Strom zur Entnahme von Ladungsträgern aus der positiven Elektrode führt, kann hieraus der zeitliche Verlauf der in der positiven Elektrode vorhandenen Ladungsmenge, insbesondere

mittels $$Q_+(t) = Q_0 - \int_0^t I(t')\mathrm{d}t'$$, bestimmt werden.

Gemäß einer vorteilhaften Ausgestaltung der Erfindung wird die Ruhespannung $V_0(t)$ aus der angelegten Spannung $V(t)$ und einer Überspannung $\eta(t)$ der Batteriezelle ermittelt.

Das ist deshalb von Vorteil, da sich die angelegte, zwischen den Elektroden messbare Spannung $V(t)$ aus der Ruhespannung $V_0(t)$ und der Überspannung $\eta(t)$ zusammensetzt. Mit anderen Worten ist $V(t) = V_0(t) + \eta(t)$. Die Überspannung $\eta(t)$ ist hierbei durch kinetische Effekte, beispielsweisen durch Diffusion und/oder Oberflächeneffekte, verursacht. Ist die Überspannung $\eta(t)$ somit bekannt, so kann mittels dieser und der gemessen angelegten Spannung $V(t)$ die Ruhespannung durch $V_0(t) = V(t) - \eta(t)$ ermittelt werden.

In einer vorteilhaften Weiterbildung der Erfindung wird die Ruhespannung $V_0(t)$ innerhalb eines stromlosen Zeitbereichs ermittelt.

Das ist insbesondere dann von Vorteil, wenn die Überspannung nicht bekannt ist. In diesem Fall ist es erforderlich die Ruhespannung zu messen. Dies kann vorteilhafterweise durch stromlose Zeitbereiche erfolgen, da in diesen die zwischen den Elektroden messbare Spannung ein Abklingverhalten aufweist. Der asymptotische Wert des genannten Abklingverhaltens ist die zu ermittelnde Ruhespannung. Mit anderen Worten kann der Stromfluss während der Formierung in definierten Intervallen (stromlose Zeitbereiche) kurzzeitig unterbrochen werden, sodass die Überspannung abklingt und die Ruhespannung zum aktuellen Zeitpunkt bestimmt werden kann.

Gemäß einer vorteilhaften Ausgestaltung der Erfindung wird die Ruhespannung $V_0(t)$ aus einem Abklingverhalten der Spannung $V(t)$ innerhalb des stromlosen Zeitbereichs ermittelt.

Vorteilhafterweise ist es dadurch nicht erforderlich abzuwarten, bis der asymptotische Wert der Spannung erreicht ist. Bereits aus dem Abklingverhalten kann die Ruhespannung, beispielsweise mittels eines Fits und/oder einer Extrapolation, ermittelt werden. Dadurch können vorteilhafterweise die stromlosen Zeitbereiche zur Ermittlung der Ruhespannung verkürzt werden. Wurde die aktuelle Ruhespannung ermittelt, kann die Formierung bis zum nächsten stromlosen Bereich weitergeführt werden.

In einer vorteilhaften Weiterbildung der Erfindung wird für jede Elektrode eine Ruhepotentialkennlinie $\varphi_\pm(Q_\pm)$ bereitgestellt, und die Ladungsmenge der negativen Elektrode $Q_-(t)$ mittels der Ruhepotentialkennlinien $\varphi_\pm(Q_\pm)$, der ermittelten Ladungsmenge der positiven Elektrode $Q_+(t)$ und der Ruhespannung $V_0(t)$ ermittelt.

Typischerweise sind die Ruhepotentialkennlinien der Elektroden für den jeweiligen Batteriezellentyp bekannt. Diese hängen typischerweise von einem Legierungsgrad und/oder der chemischen Zusammensetzung der jeweiligen Elektrode ab. Die Ruhespannung ist somit über die Ruhepotentiale von $Q_-(t)$ und $Q_+(t)$ abhängig, das heißt $V_0 = V_0(Q_-, Q_+)$, wobei die zeitliche Abhängigkeit nicht ausgeschrieben wurde. Da die Ruhespannung $V_0$ und die Ladungsmenge $Q_+$ der positiven Elektrode zum jeweiligen Zeitpunkt bereits ermittelt sind, kann durch $V_0 = V_0(Q_-, Q_+)$ die Ladungsmenge $Q_-$ der negativen Elektrode ermittelt werden. Mit anderen Worten gilt dann zum jeweiligen Zeitpunkt $Q_- = Q_-(V_0, Q_+)$.

Besonders bevorzugt wird hierbei der Zusammenhang $V_0(t) = \varphi_+(Q_+) - \varphi_-(Q_-)$ verwendet.

Mit anderen Worten ergibt sich die Ruhespannung im Gleichgewicht aus dem Potentialunterschied der Elektroden.

Der Verlauf des negativen Elektrodenpotentials $\varphi_-(Q_-)$ ist insbesondere von der spezifischen Zusammensetzung der Elektrode abhängig und kann, insbesondere bei reinen Grafit-Anoden, in bestimmten Bereichen einen flachen Verlauf aufweisen. Dies macht eine genaue Bestimmung von $Q_-$ mittels des Elektrodenpotentials aufwendiger. Entsprechend werden möglichst genaue Werte der Ruhespannung benötigt, um die Ladungsmenge auch in diesen Bereichen mit genügender Genauigkeit bestimmen zu können. Falls dies nicht möglich sein sollte, so kann die Methode auf die nicht-flachen Bereiche von $\varphi_-(Q_-)$ beschränkt werden.

Gemäß einer vorteilhaften Ausgestaltung der Erfindung erfolgt die Ermittlung der aktuellen Ladungsmengen $Q_{SEI}(t)$, $Q_-(t)$ innerhalb eines stromlosen Zeitbereichs des Formierungsprozesses.

Innerhalb des stromlosen Zeitbereichs kann vorteilhafterweise die Ruhespannung ermittelt werden, insbesondere durch eine Messung bestimmt werden. Es ist somit vorteilhaft, dass Verfahren zur Ermittlung der Ladungsmenge ebenfalls innerhalb des stromlosen Zeitbereichs durchzuführen.

Da sich $Q_+$ aus einer Strommessung kumulativ ergibt und die Ruhespannung bestimmt wurde, können die momentanen Elektrodenpotentiale $\varphi_+(Q_+)$ und $\varphi_-(Q_-)$ bestimmt werden. Da die Potentialverläufe bekannt sind, ergibt sich hieraus insbesondere die momentan in der negativen Elektrode gespeicherte Ladung $Q_-$. Aus diesen Ladungsmengen ergibt sich schließlich die bis zum aktuellen Zeitpunkt für die SEI Formierung aufgewandte Ladungsmenge $Q_{SEI}$.

In einer vorteilhaften Weiterbildung der Erfindung werden/wird die angelegte Spannung, eine Stromstärke und/oder eine Temperatur als Stellgröße der Regelung verwendet.

Mit anderen Worten werden zur Regelung neben der Spannung bevorzugt weitere Größen verwendet, insbesondere die Stromstärke, die Temperatur, und/oder eine Luftfeuchtigkeit. Das ist deshalb von Vorteil, da die genannten Größen einen Einfluss auf die Sollwertkurve $Q_{SEI}(Q_-)$ hatten und somit ebenfalls auf eine aktuelle Formierung.

Gemäß einer vorteilhaften Ausgestaltung der Erfindung wird der Formierungsprozess mit einer entladenen Batteriezelle gestartet.

Vorteilhafterweise kann dadurch eine verbesserte und konsistentere SEI Formierung erreicht werden. Weiterhin sind in der Herstellung die Batteriezellen vor ihrer Formierung typischerweise zunächst nicht geladen, das heißt entladen.

In einer vorteilhaften Weiterbildung der Erfindung wird eine Lithium-Ionen-Batteriezelle verwendet, insbesondere hergestellt.

Weiterhin können bevorzugt Natrium-Ionen-Batteriezellen vorgesehen sein beziehungsweise hergestellt werden.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:

Figur 1　eine schematische Darstellung der Verschiebung von Ladungsmengen während einer Formierung einer Batteriezelle;

Figur 2　zwei Diagramme bezüglich eines Formierungsprozesses und einer Ermittlung der Ruhespannung;

Figur 3　mehrere Diagramme bezüglich eines Formierungsprozesses;

Figur 4　ein Schema zur Regelung eines Formierungsprozesses; und

Figur 5　eine $Q_{SEI}(Q_-)$ Kennlinie sowie Messpunkte einer zu formierenden Batteriezelle.

Gleichartige, gleichwertige oder gleichwirkende Elemente können in einer der Figuren oder in den Figuren mit denselben Bezugszeichen versehen sein.

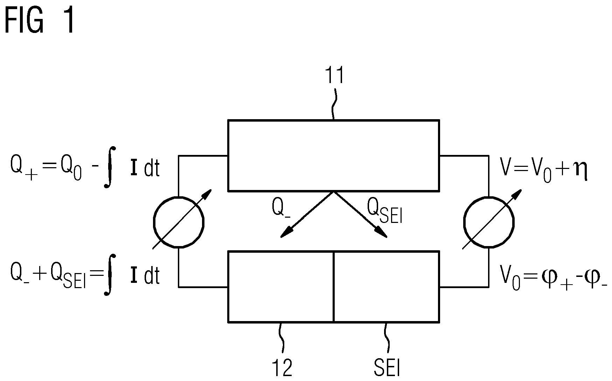

Die Figur 1 zeigt eine schematische Darstellung der Verschiebung von Ladungsmengen während einer Formierung einer Batteriezelle.

Hierbei zeigt die Figur 1 eine Batteriezelle mit einer positiven Elektrode 11 und einer negativen Elektrode 12.

Die positive Elektrode 11 weist zum Beginn der Formierung die Ladungsmenge $Q_0$ auf. Während der Formierung wird diese Ladungsmenge durch einen Stromfluss $I$, der durch eine anlege Spannung 7 induziert ist, auf $Q_-$ und $Q_{SEI}$ aufgeteilt, wobei zu einem Zeitpunkt ebenfalls eine restliche Ladung $Q_+$ auf der positiven Elektrode 11 zurückbleibt. Die negative Elektrode 12 weist somit die Ladungsmenge $Q_-$ auf und die durch die SEI Formierung verbrauchte Ladung $Q_{SEI}$. Es gilt somit $Q_0 = Q_+(t) + Q_-(t) + Q_{SEI}(t)$. Somit stellt die Figur 1 den grundsätzlichen Zusammenhang zwischen den messbaren Größen und den Potentialen beziehungsweise den gespeicherten Ladungsmengen in den jeweiligen Elektroden 11, 12 beziehungsweise der SEI dar.

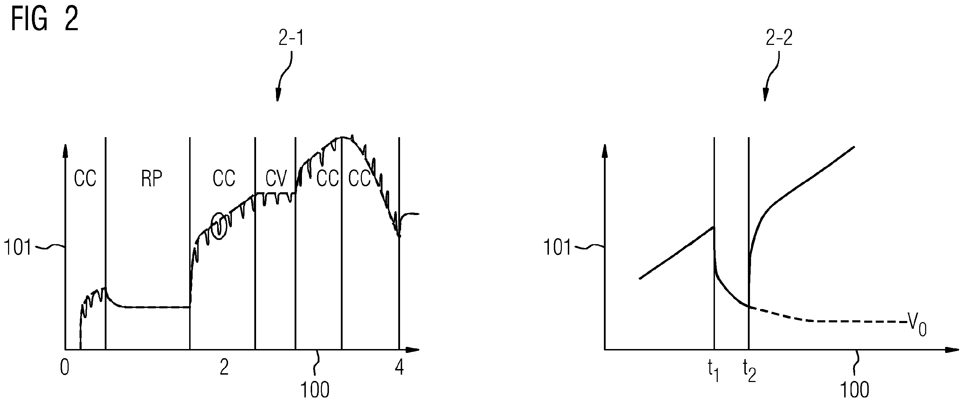

Die Figur 2 zeigt zwei Diagramme 2-1, 2-2 bezüglich eines Formierungsprozesses (Diagramm 2-1) und einer Ermittlung der Ruhespannung (Diagramm 2-2).

An den Abszissen 100 der Diagramme 2-1, 2-2 ist jeweils die Zeit in beliebigen Einheiten aufgetragen.

An den Ordinaten 101 der Diagramme 2-1, 2-2 ist jeweils die Spannung in beliebigen Einheiten aufgetragen.

Das Diagramm 2-1 zeigt einen exemplarischen Spannungsverlauf eines Formierungsprozesses. Hierbei wechseln sich Phasen konstanter Spannung (CV), Phasen konstanter Stromstärke (CC) mit Ruhephasen (RP) ab.

Zu mehreren Zeitpunkten erfolgt ein Ermitteln der jeweiligen (zeitabhängigen) Ruhespannung durch stromlose Zeitbereiche, das heißt in diesen Bereichen werden weder Spannungen noch Stromstärken vorgegeben. Die genannten Zeitbereiche zeigen sich im Diagramm 2-1 durch nach unten gerichtete Spitzen.

Im Diagramm 2-2 ist ein Spannungsverlauf einer der Spitze vergrößert dargestellt. Es zeigt sich ein Abklingverhalten der Spannung mittels welchem die (asymptotische) Ruhespannung (gestrichelte Linie) ermittelt werden kann. Dabei verringert sich die messbare Spannung, da die Überspannung abklingt. Aus dem Abklingverhalten kann der Wert der zu erwartenden Ruhespannung extrapoliert werden (gestrichelte Linie). Sobald die Ruhespannung $V_0$ zum Zeitpunkt $t_1$ ermittelt wurde, kann der Prozess zum Zeitpunkt $t_2$ fortgeführt werden.

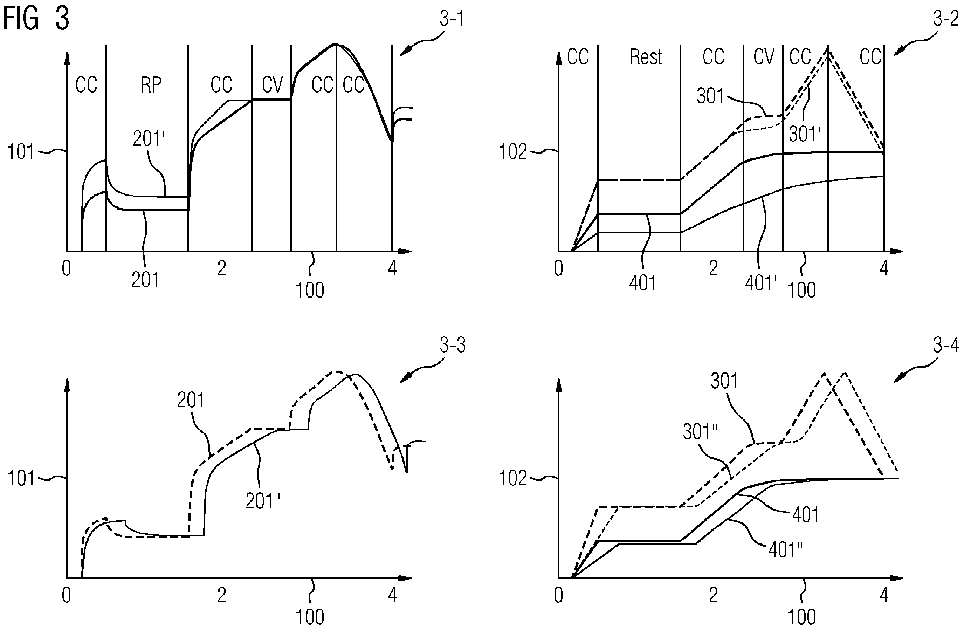

Die Figur 3 zeigt mehrere Diagramme 3-1 bis 3-4 bezüglich eines Formierungsprozesses.

An den Abszissen 100 der Diagramme 3-1 bis 3-4 ist jeweils die Zeit in beliebigen Einheiten aufgetragen.

An den Ordinaten 101 der Diagramme 3-1 und 3-3 ist die jeweilige Spannung in beliebigen Einheiten aufgetragen.

An den Ordinaten 101 der Diagramme 3-2 und 3-4 ist die jeweilige Ladungsmenge in beliebigen Einheiten aufgetragen.

Das Diagramm 3-1 zeigt einen typischen Spannungsverlauf eines Formierungsprozesses ohne ein Regelungsverfahren gemäß der Erfindung und/oder einer ihrer Ausgestaltungen für zwei Batteriezellen (Kurven 201, 201'). Hierbei entspricht die Kurve 201 einer Referenzbatteriezelle (Golden Sample) und somit einem Referenzformierungsprozess.

Das Diagramm 3-2 zeigt die übertragene Ladungsmenge $Q_- + Q_{SEI}$ (Kurven 301, 301') sowie die SEI Ladungsmengen $Q_{SEI}$ (Kurven 401, 401'). Aus dem Diagramm 3-2 ist erkennbar, dass sich die SEI Ladungsmengen der weiteren Batteriezelle (Kurve 401') und Referenzbatteriezelle (Kurve 401) ohne ein Regelungsverfahren gemäß der Erfindung und/oder einer ihrer Ausgestaltungen unterscheiden.

Das Diagramm 3-3 zeigt einen exemplarischen Spannungsverlauf eines Formierungsprozesses gemäß einem Regelungsverfahren gemäß einer Ausgestaltungen der Erfindung für zwei Batteriezellen (Kurven 201, 201"). Hierbei entspricht die Kurve 201 einer Referenzbatteriezelle (Golden Sample) und somit einem Referenzformierungsprozess.

Das Diagramm 3-4 zeigt die übertragene Ladungsmenge $Q_- + Q_{SEI}$ (Kurven 301, 301") sowie die SEI Ladungsmengen $Q_{SEI}$ (Kurven 401, 401"). Aus dem Diagramm 3-4 ist erkennbar, dass sich die SEI Ladungsmengen der weiteren Batteriezelle (Kurve 401") und der Referenzbatteriezelle (Kurve 401) durch ein Regelungsverfahren gemäß der Erfindung und/oder einem ihrer Ausgestaltungen im Wesentlichen gleichen. Somit kann eine zum Golden Sample vergleichbare SEI Formierung für die weitere Batteriezelle beziehungsweise weitere Batteriezellen erreicht werden.

Die Diagramme 3-3 und 3-4 verdeutlichen somit, wie das vorliegende Regelungsverfahren den Formierungsprozess verbessert. Im dargestellten Beispiel wurde die Stromstärke zum Erreichen der Sollwertkurve $Q_{SEI}(Q_-)$ durch die Regelung verringert, was im Vergleich zu den Diagrammen 3-1 und 3-2 zu geringeren Überspannungen führt und die Prozessdauer erhöht. Dafür werden jedoch bei beiden Prozessen die gleichen Verhältnisse bezüglich der Ladungsmengen $Q_{SEI}$ und $Q_-$ erreicht. Dies ermöglicht die gleiche SEI Formierung bei jeder individuellen Batteriezelle und sichert und verbessert somit die Qualität des Formierungsprozesses.

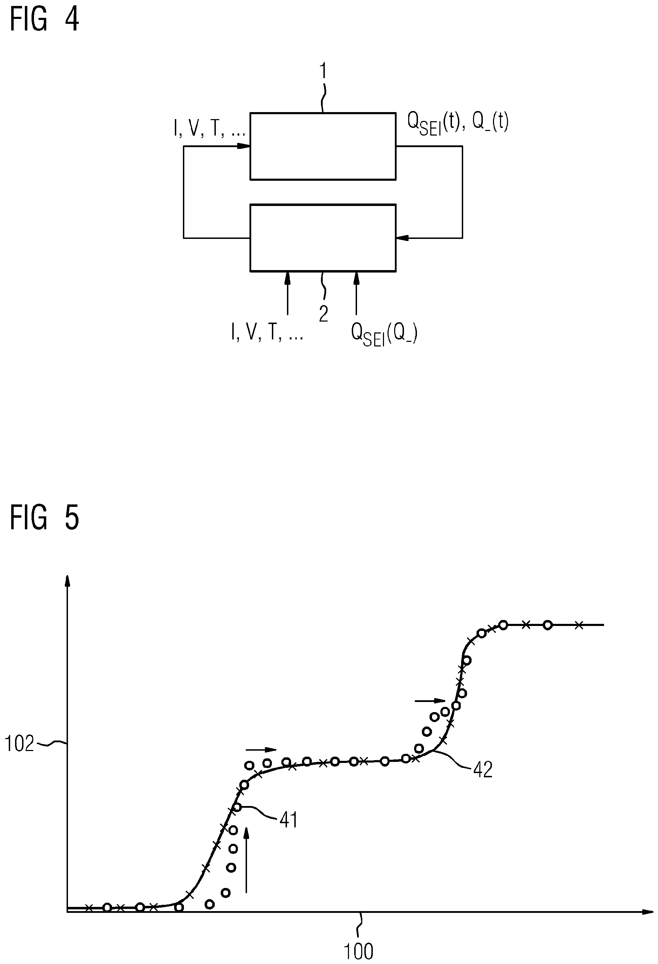

Die Figur 4 zeigt ein Schema zur Regelung eines Formierungsprozesses gemäß einer Ausgestaltung der Erfindung.

Der in der Figur 4 dargestellte Regelkreis umfasst eine Batteriezelle 1 sowie eine Regeleinheit 2. Die Regeleinheit 2 ist dazu ausgebildet ein Regelungsverfahren gemäß der Erfindung und/oder einer ihrer Ausgestaltungen durchzuführen. An die Batteriezelle 1 beziehungsweise zwischen den Elektroden der Batteriezelle 1 wird eine zeitabhängige Spannung 7 und/oder Stromstärke *I* als primäre Stellgrößen der Regelung angelegt. Weiterhin können durch die Regelung eine Temperatur, eine Luftfeuchtigkeit und/oder weitere Einflussgrößen auf den Formierungsprozess berücksichtigt werden.

Die verwendeten Startwerte für die genannten Stellgrößen entsprechen dabei denen aus dem Golden Sample beziehungsweise dem Formierungsprozess des Golden Samples. Durch das vorgestellte Regelungsverfahren können $Q_-$ und $Q_{SEI}$ bestimmt und als Regelgrößen verwendet werden. Der Regler 2 beziehungsweise die Regeleinheit 2 vergleicht diese Werte mit der bereitgestellten Sollwertkurve $Q_{SEI}(Q_-)$ aus der Golden Sample Messung und stellt die Stellgröße entsprechend der aktuellen Regelabweichungen ein.

Der Formierungsprozess des Golden Samples muss vorab durchgeführt werden. Dieser stellt somit den im genannten Sinne einen idealen Formierungsprozess dar, durch welchen eine in diesem Sinne ideale SEI und somit ideale Batteriezelle (Golden Sample) erreicht wird. Dieser Prozess dient somit als Vorbild für eine optimale SEI Formierung und muss so durchgeführt werden, dass die Ruhespannung an einer ausreichenden Anzahl an Zeitpunkten bekannt ist. Hierzu können verschiedene Methoden aus dem Stand der Technik verwendet werden und/oder die in der Erfindung vorgestellten Verfahren zum Ermitteln der Ruhespannung verwendet werden. Während des Prozesses können alle relevanten elektrischen Parameter aufgezeichnet werden, insbesondere der Strom beziehungsweise die Stromstärke sowie die Ruhespannung und weitere relevante Umgebungsparameter, beispielsweise eine Temperatur.

Für jede individuelle Zelle werden diese Parameter ebenfalls während der Formierung erfasst, wobei mit dem gleichen Prozess wie beim Golden Sample gestartet werden kann.

Falls, wie in Figur 3 dargestellt, die gleiche Prozessführung für die individuelle Zelle verwendet wird, kann dies zu unterschiedlichen Messwerten führen. Beispielsweise tritt im ersten Schritt bei der Ladung mit konstantem Strom (CC) eine höhere Überspannung im Vergleich zum Golden Sample auf. Das kann dazu führen, dass mehr Strom zur Aufladung der Zelle verwendet wird und weniger Strom beziehungsweise Ladungsmenge in die SEI Formierung fließt. Das hat beispielsweise einen höheren Spannungswert am Ende der folgenden Ruhestufe (Rest) zur Folge (vgl. Figur 3, Diagramme 3-1 und 3-2). Während der folgenden Schritte bei konstantem Strom beziehungsweise bei konstanter Spannung (CV) führt dies dazu, dass sich die SEI nicht im gleichen Maße weiterbildet, wie beim Golden Sample und sich bezüglich ihrer Beschaffenheit, und der in ihr aufgenommenen Ladungsmenge, am Ende des Formierungsprozesses davon unterscheidet (vgl. Figur 3, Diagramme 3-1 und 3-2).

Die Figur 5 zeigt eine $Q_{SEI}(Q_-)$ 42 Kennlinie sowie Messpunkte einer zu formierenden (weiteren) Batteriezelle.

An der Abszisse 100 des Diagramms ist die Ladungsmenge $Q_-$ in beliebigen Einheiten aufgetragen.

An der Ordinate 102 des Diagramms ist die die Ladungsmenge $Q_{SEI}$ in beliebigen Einheiten aufgetragen.

Die Sollwertkurve 42 entspricht einem Verlauf von $Q_{SEI}(Q_-)$ gemäß einer Referenzbatteriezelle, das heißt gemäß einem Golden Sample. Weiterhin sind in dem Diagramm aktuelle Messwerte 41 einer Formierung einer weiteren Batteriezelle dargestellt, die gemäß einem Regelungsverfahren gemäß einer Ausgestaltung der vorliegenden Erfindung formiert wird. Die Regelung beziehungsweise das Regelungsverfahren führt zu einem gleichen Verlauf der Kurven $Q_{SEI}(Q_-)$ während des Formierungsprozesses. Mit anderen Worten reduziert die Regelung die Abweichung der Messpunkte 41 von der Sollwertkurve 42.

Beispielsweise wird bei einem CC-Schritt des Formierungsprozesses zunächst die Stromstärke aus der Golden Sample Messung als Startwert für die Stellgröße des Prozesses verwendet. Der Prozess wird bis zum nächsten Zeitpunkt durchgeführt, an welchem er für eine Ermittlung der Ruhespannung unterbrochen wird. Hieraus können die Werte $Q_-$ und $Q_{SEI}$ zum jeweiligen Zeitpunkt als aktuelle Messwerte 41 ermittelt werden.

Sollte sich das Verhältnis dieser Werte dabei von der im Golden Sample Prozesses ermittelten Sollwertkurve $Q_{SEI}(Q_-)$ 42 unterscheiden, so wird beispielsweise die Stromstärke (Stellgröße) entsprechend durch die Regelung angepasst beziehungsweise eingestellt. Auf welche Art die Stromstärke und somit die die daraus resultierenden Überspannungen angepasst werden kann dabei von der Chemie der Batteriezelle abhängen.

Bei einem CV-Schritt wird ein vorgegebener Spannungswert angelegt. Hier kann ein $Q_{SEI}$ Wert als Kriterium definiert werden, bis zu welchem die Spannung gehalten wird. Dieser ersetzt dabei die Stromstärke, welche typischerweise als Abbruchkriterium definiert wird. Während einer Ruhestufe findet keine Verschiebung von Ladungsmengen statt, sodass diese Stufen im Rahmen der Regelung typischerweise unverändert übernommen werden.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

Bezugszeichenliste

| 2-1,2-2 | Diagramm |
| 3-1,...,3-4 | Diagramm |

| 1 | Batteriezelle |
| 2 | Regeleinheit |
| 11 | positive Elektrode |
| 12 | negative Elektrode |
| 41 | aktuelle Ladungsmengen |
| 42 | Sollwertkurve |

| 100 | Abszisse |
| 101 | Ordinate |
| 102 | Ordinate |
| SEI | Feststoff-Elektrolyt-Grenzphase |

| 201, 201', 201" | Spannungsverlauf |
| 301, 301', 301" | Ladungsmengenverlauf |
| 401, 401', 401" | SEI-Ladungsmengenverlauf |

**Patentansprüche**

1. Verfahren zur Ermittlung einer Ladungsmenge $Q_{SEI}(t)$ einer Feststoff-Elektrolyt-Grenzphase (SEI) einer Batteriezelle (1), wobei die Batteriezelle (1) eine positive und negative Elektrode (11, 12) aufweist, und an die Batteriezelle (1) eine zeitabhängige Spannung V(t) angelegt wird, **gekennzeichnet durch** folgende Schritte:

- Ermitteln einer Ruhespannung $V_0(t)$ der Batteriezelle (1);
- Ermitteln einer Ladungsmenge $Q_+(t)$ der positiven Elektrode (11);
- Ermitteln einer Ladungsmenge $Q_-(t)$ der negativen Elektrode (12) mittels der ermittelten Ladungsmenge der positiven Elektrode $Q_+(t)$ (11) und der ermittelten Ruhespannung $V_0(t)$; und
- Ermitteln der Ladungsmenge $Q_{SEI}(t)$ der Feststoff-Elektrolyt-Grenzphase (SEI) mittels den ermittelten Ladungsmengen $Q_+(t)$, $Q_-(t)$ der Elektroden (11, 12).

2. Verfahren gemäß Anspruch 1, **gekennzeichnet dadurch, dass** die Ladungsmenge $Q_{SEI}(t)$ über $Q_{SEI}(t)$ = $Q_0$ - $Q_+(t)$ - $Q_-(t)$ ermittelt wird, wobei $Q_0$ eine Gesamtladungsmenge der Batteriezelle (1) bezeichnet.

3. Verfahren gemäß Anspruch 1 oder 2, **gekennzeichnet dadurch, dass** die Ladungsmenge $Q_+(t)$ der positiven Elektrode (11) mittels des mit der angelegten Spannung V(t) assoziierten Stromflusses $I(t)$ ermittelt wird.

4. Verfahren gemäß einem der vorhergehenden Ansprüche, **gekennzeichnet dadurch, dass** die Ruhespannung $V_0(t)$ aus der angelegten Spannung V(t) und einer Überspannung $\eta(t)$ der Batteriezelle (1) ermittelt wird.

5. Verfahren gemäß einem der vorhergehenden Ansprüche, **gekennzeichnet dadurch, dass** die Ruhespannung $V_0(t)$ innerhalb eines stromlosen Zeitbereichs ermittelt wird.

6. Verfahren gemäß Anspruch 5, **gekennzeichnet dadurch, dass** die Ruhespannung $V_0(t)$ aus einem Abklingverhalten der Spannung V(t) innerhalb des stromlosen Zeitbereichs ermittelt wird.

7. Verfahren gemäß einem der vorhergehenden Ansprüche, **gekennzeichnet dadurch, dass** für jede Elektrode (11, 12) eine Ruhepotentialkennlinie $\varphi_\pm(Q_\pm)$ bereitgestellt wird, und die Ladungsmenge der negativen Elektrode $Q_-(t)$ (12) mittels der Ruhepotentialkennlinien $\varphi_\pm(Q_\pm)$, der ermittelten Ladungsmenge der positiven Elektrode $Q_+(t)$ (11) und der Ruhespannung $V_0(t)$ ermittelt wird.

8. Verfahren gemäß Anspruch 7, **gekennzeichnet dadurch, dass** hierzu der Zusammenhang $V_0(t)$ = $\varphi_+(Q_+)$ - $\varphi_-(Q_-)$ verwendet wird.

9. Verfahren zur Regelung eines Formierungsprozesses einer Batteriezelle (1) mit einer positiven und negativen Elektrode (11, 12), wobei zur wenigstens teilweisen Ausbildung einer Feststoff-Elektrolyt-Grenzphase (SEI) an die Batteriezelle (1) eine zeitabhängige Spannung $V(t)$ angelegt wird, **gekennzeichnet durch** folgende Schritte:

- Bereitstellen einer Sollwertkurve $Q_{SEI}(Q_-)$ (42), wobei $Q_{SEI}$ eine Ladungsmenge der Feststoff-Elektrolyt-Grenzphase (SEI) und $Q_-$ eine Ladungsmenge der negativen Elektrode (12) bezeichnet; und
- Regeln des Formierungsprozesses gemäß der Sollwertkurve $Q_{SEI}(Q_-)$ (42) durch ein Ermitteln von aktuellen Ladungsmengen $Q_{SEI}(t)$ (41) der Feststoff-Elektrolyt-Grenzphase (SEI) und von zugehörigen aktuellen Ladungsmengen $Q_-(t)$ (41) der negativen Elektrode (12) gemäß einem Verfahren nach einem der vorhergehenden Ansprüche.

10. Verfahren gemäß Anspruch 9, **gekennzeichnet dadurch, dass** die Ermittlung der aktuellen Ladungsmengen $Q_{SEI}(t)$, $Q_-(t)$ innerhalb eines stromlosen Zeitbereichs des Formierungsprozesses erfolgt.

11. Verfahren gemäß Anspruch 9 oder 10, **gekennzeichnet dadurch, dass** die angelegte Spannung, eine Stromstärke und/oder eine Temperatur als Stellgröße der Regelung verwendet werden/wird.

12. Verfahren gemäß einem der Ansprüche 9 bis 11, **gekennzeichnet dadurch, dass** der Formierungsprozesses mit einer entladenen Batteriezelle (1) gestartet wird.

13. Herstellungsverfahren einer Batteriezelle (1), bei dem ein Formierungsprozess der Batteriezelle (1) erfolgt, **gekennzeichnet dadurch, dass** der Formierungsprozess mittels eines Verfahrens gemäß einem der Ansprüche 9 bis 12 geregelt wird.

14. Herstellungsverfahren gemäß Anspruch 13, **gekennzeichnet dadurch, dass** eine Lithium-Ionen-Batteriezelle (1) hergestellt wird.

15. Vorrichtung zur Regelung eines Formierungsprozesses einer Batteriezelle (1), **dadurch gekennzeichnet, dass** die Vorrichtung wenigstens eine Regeleinheit (2) umfasst, wobei die Regeleinheit (2) dazu ausgebildet ist, ein Verfahren gemäß einem der Ansprüche 9 bis 12 durchzuführen

FIG 1

$$Q_+ = Q_0 - \int \mathbf{I}\, dt$$

$$Q_- + Q_{SEI} = \int \mathbf{I}\, dt$$

$$V = V_0 + \eta$$

$$V_0 = \varphi_+ - \varphi_-$$

11

$Q_-$    $Q_{SEI}$

12    SEI

FIG 2

2-1

CC | RP | CC | CV | CC | CC

101

0 · · 2 · 100 · 4

2-2

$t_1$ · $t_2$ · 100

$V_0$

101

FIG 3

FIG 4

FIG 5

**EUROPÄISCHER RECHERCHENBERICHT**

Europäisches Patentamt
European Patent Office
Office européen des brevets

Nummer der Anmeldung

EP 24 17 2769

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | SCHINDLER STEFAN ET AL: "A novel mechanistic modeling framework for analysis of electrode balancing and degradation modes in commercial lithium-ion cells", JOURNAL OF POWER SOURCES, ELSEVIER, AMSTERDAM, NL, Bd. 343, 20. Januar 2017 (2017-01-20), Seiten 226-236, XP029918333, ISSN: 0378-7753, DOI: 10.1016/J.JPOWSOUR.2017.01.026 * das ganze Dokument * ----- | 1-15 | INV. H01M10/04 H01M10/42 H01M10/44 H01M10/48 G01R31/378 G01R31/385  ADD. H01M10/0525 |
| A | DE 11 2018 007494 T5 (MITSUBISHI ELECTRIC CORP [JP]) 31. Dezember 2020 (2020-12-31) * Absätze [0062] - [0083] * ----- | 1-15 | |
| A | TIAN YU ET AL: "Detecting undesired lithium plating on anodes for lithium-ion batteries - A review on the in-situ methods", APPLIED ENERGY, ELSEVIER SCIENCE PUBLISHERS, GB, Bd. 300, 13. Juli 2021 (2021-07-13), XP086732412, ISSN: 0306-2619, DOI: 10.1016/J.APENERGY.2021.117386 [gefunden am 2021-07-13] * das ganze Dokument * ----- | 1-15 | **RECHERCHIERTE SACHGEBIETE (IPC)**  H01M |

Der vorliegende Recherchenbericht wurde für alle Patentansprüche erstellt

| Recherchenort | Abschlußdatum der Recherche | Prüfer |
|---|---|---|
| Den Haag | 18. Oktober 2024 | Knoflacher, Andreas |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**    EP 24 17 2769

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-10-2024

| Im Recherchenbericht angeführtes Patentdokument | Datum der Veröffentlichung | Mitglied(er) der Patentfamilie | | Datum der Veröffentlichung |
|---|---|---|---|---|
| DE 112018007494 T5 | 31-12-2020 | CN | 111954823 A | 17-11-2020 |
| | | DE | 112018007494 T5 | 31-12-2020 |
| | | JP | 6768100 B2 | 14-10-2020 |
| | | JP | 2019184581 A | 24-10-2019 |
| | | US | 2020393518 A1 | 17-12-2020 |
| | | WO | 2019202752 A1 | 24-10-2019 |

EPO FORM P0461

Für nähere Einzelheiten zu diesem Anhang : siehe Amtsblatt des Europäischen Patentamts, Nr.12/82